(19) Europäisches Patentamt
European Patent Office
Office européen des brevets

(11) EP 2 738 819 B1

(12) **EUROPEAN PATENT SPECIFICATION**

(45) Date of publication and mention
of the grant of the patent:
**30.05.2018 Bulletin 2018/22**

(21) Application number: **12817558.5**

(22) Date of filing: **16.03.2012**

(51) Int Cl.:
*H01L 31/04* (2014.01)  *H01L 31/0747* (2012.01)
*H01L 31/0224* (2006.01)  *H01L 31/056* (2014.01)

(86) International application number:
**PCT/JP2012/056859**

(87) International publication number:
**WO 2013/014967 (31.01.2013 Gazette 2013/05)**

(54) **SOLAR CELL**

SOLARZELLE

CELLULE SOLAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.07.2011 JP 2011163823**

(43) Date of publication of application:
**04.06.2014 Bulletin 2014/23**

(73) Proprietor: **Panasonic Intellectual Property
Management Co., Ltd.**
**Osaka-shi, Osaka 540-6207 (JP)**

(72) Inventor: **NAKAMURA, Yuya**
**Moriguchi-shi**
**Osaka 570-8677 (JP)**

(74) Representative: **Glawe, Delfs, Moll**
**Partnerschaft mbB**
**von Patent- und Rechtsanwälten**
**Postfach 13 03 91**
**20103 Hamburg (DE)**

(56) References cited:
**EP-A1- 2 261 995      EP-A2- 0 915 523**
**WO-A1-2008/059857   WO-A1-2009/116578**
**WO-A1-2009/116580   WO-A1-2011/115206**
**DE-A1-102004 032 810  JP-A- 9 237 910**
**JP-A- 11 220 154      JP-A- H07 321 362**
**JP-A- H08 508 368     US-A- 5 569 332**

**Description**

**FIELD OF THE INVENTION**

The present invention relates to a solar cell.

**BACKGROUND**

Solar cells have attracted attention in recent years as an energy source with a low environmental impact. A solar cell is described in Patent Document 1 which has a semiconductor substrate, a silicon layer arranged on the main surface of the semiconductor substrate on the back surface side, a transparent conductive layer arranged on the silicon layer, and a reflective layer of Ag arranged on the transparent conductive layer. Patent Document 2 discloses a semiconductor layer, a transparent conductive film, a structured low-refractive-index layer and a metal layer laminated together.

Prior Art Documents

Patent Documents

Patent Document 1: PCT Application Translation No. 8-508368

Patent Document 2: JPH 7-321362

**SUMMARY**

Problem Solved by the Invention

There has been growing demand in recent years for a solar cell with even greater photoelectric conversion efficiency.
The present invention provides a solar cell with improved photoelectric conversion efficiency.

Means of Solving the Problem

The solar cell of the present invention includes a photoelectric conversion unit, a metal layer, and an intermediate layer. The photoelectric conversion unit includes a transparent conductive layer on a surface. The metal layer is arranged on the transparent conductive layer. The intermediate layer is arranged between the metal layer and the transparent conductive layer and shaped in stripes each of which extends in a first direction, such that the surface of the metal layer is formed in an uneven shape due to the stripe-shaped intermediate layer. The intermediate layer has a smaller extinction coefficient than that of the metal layer. Linear electrodes are formed on the surface of the metal layer and extending in the first direction.

Effect of the Invention

The present invention is able to provide a solar cell with improved photoelectric conversion efficiency.

**BRIEF DESCRIPTION OF THE DRAWINGS**

FIG. 1 is a simplified cross-sectional view of the solar cell in an embodiment.
FIG. 2 is a simplified rear view of the solar cell in the embodiment.
FIG. 3 is a simplified cross-sectional view in which a portion of the solar cell in the embodiment has been enlarged. In FIG. 3, the cross-sectional hatching has been omitted.
FIG. 4 is a graph representing the optical reflectance of the metal layer of the solar cell in the embodiment at an optical wavelength of 1000 nm.
FIG. 5 is a graph representing the reflectivity of the metal layer of the solar cell in the embodiment at an optical wavelength of 1000 nm.

FIG. 6 is a graph representing the reflectivity of the metal layer of the solar cell in a reference example at an optical wavelength of 1000 nm.

## DETAILED DESCRIPTION

The following is an explanation of examples of preferred embodiments of the present invention. The following embodiments are merely examples. The present invention is not limited by the following embodiments in any way.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

### 1st Embodiment

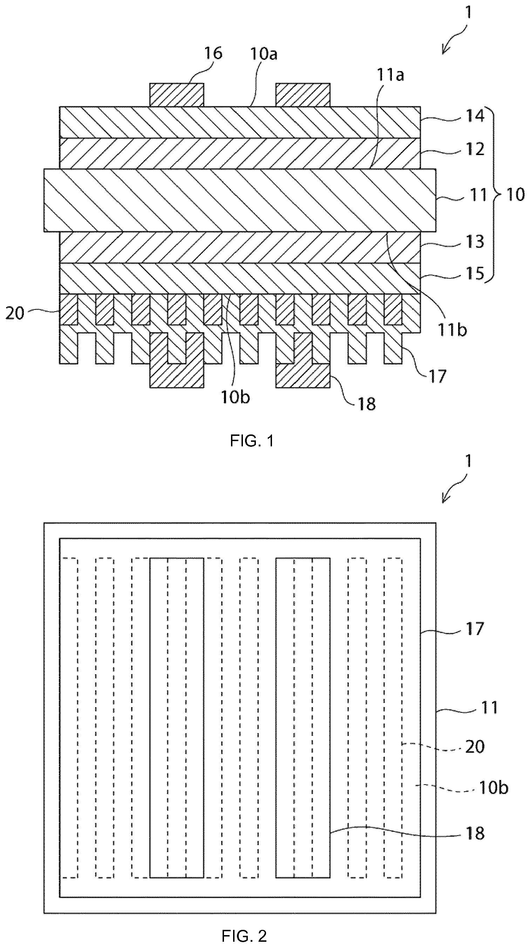

FIG. 1 is a simplified cross-sectional view of the solar cell 1 in an embodiment. FIG. 2 is a simplified rear view of the solar cell 1.

The solar cell 1 has a photoelectric conversion unit 10. The photoelectric conversion unit 10 is the portion which generates carriers such as electrons and holes when exposed to light. The photoelectric conversion unit 10 has a substrate 11, first and second semiconductor layers 12, 13, and first and second transparent conductive layers 14, 15.

The substrate 11 is a substrate made of a semiconductor material. The substrate 11 has one type of conductivity. The substrate 11 can be constructed of a substrate made of crystalline silicon, such as a substrate of single-crystal silicon. The thickness of the substrate 11 can be 300 $\mu$m or less. The substrate 11 has first and second main surfaces 11a, 11b.

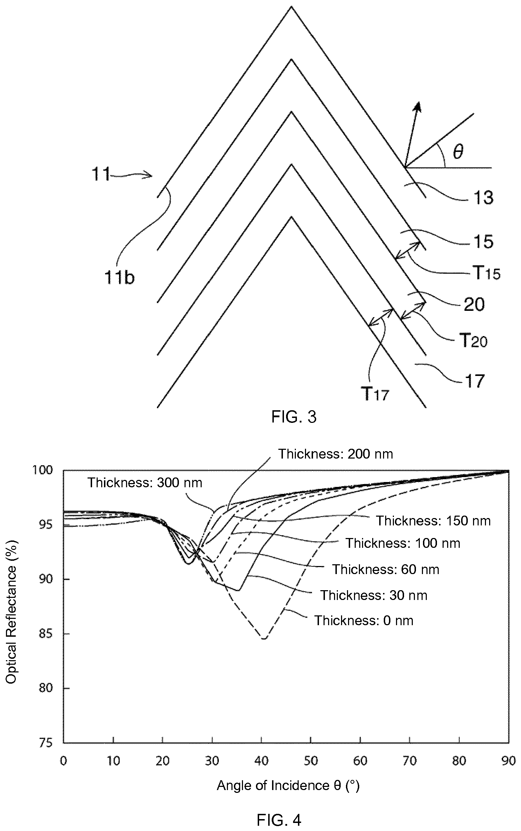

In the present embodiment, as shown in FIG. 3, each of the first and second main surfaces 11a, 11b has a textured structure. Here, "textured structure" means an uneven structure formed to suppress surface reflection and increase the amount of light absorbed by the photoelectric conversion unit. A specific example of a textured structure is a pyramidal uneven structure (pyramid or truncated pyramid) obtained by performing anisotropic etching on the surface of a single-crystal silicon substrate having a (100) plane.

A first semiconductor layer 12 is arranged on the first main surface 11a. Meanwhile, a second semiconductor layer 13 is formed on the second main surface 11b. One of the first and second semiconductor layers 12, 13 has the same type of conductivity as the substrate 11, and the other has a type of conductivity different from that of the substrate 11. The semiconductor layers 12, 13 can be made of p-type or n-type amorphous silicon. The structure of the solar cell in the present embodiment is called a HIT (registered trademark) structure.

A substantially intrinsic i-type semiconductor layer having a thickness from several Å to 250 Å that does not substantially influence the generation of power may be arranged between the semiconductor layers 12, 13.

A first transparent conductive layer 14 is arranged on the first semiconductor layer 12. The first transparent conductive layer 14 is provided so as to substantially cover the entire first semiconductor layer 12. The light-receiving surface 10a of the photoelectric conversion unit 10 is composed of the surface of the first transparent conductive layer 14.

A linear electrode (busbar portion and finger portions) 16 made of a metal such as Ag or an alloy is arranged on the first transparent conductive layer 14. This electrode 16 collects either electron or hole carriers.

A second transparent conductive layer 15 is arranged on the second semiconductor layer 13. The second transparent conductive layer 15 is provided so as to substantially cover the entire second semiconductor layer 13. The back surface 10b of the photoelectric conversion unit 10 is composed of the surface of the second transparent conductive layer 15. The light-receiving surface 10a is the main surface that primarily receives light. The solar cell 1 may generate electricity when receiving light only on the light-receiving surface 10a, or may be a bifacial light-receiving solar cell which generates electricity when receiving light on both the light-receiving surface 10a and the back surface 10b.

The transparent conductive layers 14, 15 can be composed of indium tin oxide (ITO), indium zinc oxide (IZO), aluminum zinc oxide (AZO), or gallium zinc oxide (GZO).

The thickness of the transparent conductive layers 14, 15 is 100 nm or less. In the present specification, layer thickness refers to the thickness in the direction normal to the surface of the layer, and not the thickness in the thickness direction of the substrate 11. Specifically, the thickness of the transparent conductive layer 15 is thickness $T_{15}$ in FIG. 3.

A metal layer 17 is arranged on the second transparent conductive layer 15. The metal layer 17 substantially covers the entire second transparent conductive layer 15. A linear electrode 18 made of a metal such as Ag or an alloy is arranged on the metal layer 17. The electrode 18 may have a finger portion and a busbar portion. In the solar cell 1, one of the carriers, electrons or holes, is collected by electrode 18 and the metal layer 17, and the other is collected by electrode 16.

The metal layer 17 also functions as a reflective layer. At least some of the light incident from the light-receiving surface 10a that reaches the metal layer 17 is reflected again towards the light-receiving surface 10a.

The metal layer 17 is preferably of at least one type of metal selected from a group including Ag, Cu, Ni, Mn, Cr, Sn, Mg, W, Co and Zn. Among these a metal layer 17 of Ag is preferred.

The thickness $T_{17}$ of the metal layer 17 is preferably from 100 nm to 400 nm, and more preferably from 150 nm to 300 nm. This increases the optical reflectance of the metal layer 17 while also reducing the electrical resistivity of the metal layer 17.

An intermediate layer 20 is provided between the transparent conductive layer 15 and at least a portion of the metal layer 17. The intermediate layer 20 may be provided over the entire area in which the metal layer 17 is provided but, in the present invention, the intermediate layer 20 is arranged between the transparent conductive layer 15 and a portion of the metal layer 17. In other words, the intermediate layer 20 is arranged in a portion of the area in which the metal layer 17 is provided. More specifically, as shown in FIG. 2, the intermediate layer 20 is provided as stripes extending parallel to each other at intervals in the area in which the metal layer 17 is provided.

From the standpoint of reducing the electrical resistivity, the area percentage for the area in which the intermediate layer 20 is provided relative to the area in which the metal layer 17 is provided is preferably from 20% to 80%, and more preferably from 30% to 70%.

The intermediate layer 20 has a higher electrical resistivity than the metal layer 17. Here, the electrical resistivity is determined as a general rule using carrier concentration and carrier mobility. When the carrier concentration is higher, the electrical resistivity tends to be lower. When the carrier concentration is lower, the electrical resistivity tends to be higher. However, the extinction coefficient is correlated with the carrier concentration, as understood from the Drude equation explained below. When the carrier concentration is higher, the extinction coefficient is higher. When the carrier concentration is lower, the extinction coefficient is lower. In other words, there is a correlation between electrical resistivity and the extinction coefficient. More specifically, when the carrier concentration is high and the electrical resistivity is low, the extinction coefficient is higher. When the carrier concentration is low and the electrical resistivity is high, the extinction coefficient is lower. Therefore, an intermediate layer 20 with an electrical resistivity that is higher than the metal layer 17 also has an extinction coefficient that is lower than the metal layer 17.

Equation 1

$$ N = n \cdot i\ k = \sqrt{\varepsilon_\infty (1 - A/E^2 - i\ E\Gamma)} \qquad \text{(Drude Equation)} $$

In the Drude equation, N is the complex refractive index, n is the refractive index, i is an imaginary number, k is the extinction coefficient, E is the energy of the incident light, A is a coefficient proportional to the carrier concentration, and $\varepsilon_\infty$ and $\Gamma$ are both coefficients unrelated to the carrier concentration.

The electrical resistivity of the intermediate layer 20 is greater than the electrical resistivity of the metal layer 17 preferably by a factor of 100 or more, and more preferably by a factor of 50 or more. More specifically, the electrical resistivity of the intermediate layer 20 is preferably $1 \times 10^{-3}$ $\Omega\cdot$cm or more, and more preferably $5 \times 10^{-3}$ $\Omega\cdot$cm or more.

The extinction coefficient of the intermediate layer 20 is smaller than the extinction coefficient of the metal layer 17 preferably by a factor of 0.01 or less, and more preferably by a factor of 0.002 or less. More specifically, the extinction coefficient of the intermediate layer 20 is preferably 0.1 or less, and more preferably 0.02 or less.

The intermediate layer 20 can be made of at least one type of material selected from a group including magnesium fluoride, silicon nitride, aluminum oxide, calcium fluoride, and magnesium oxide.

The refractive index of the intermediate layer 20 is preferably higher than the refractive index of the metal layer 17 but lower than the refractive index of the transparent conductive layer 15. The refractive index of the intermediate layer 20 is higher than the refractive index of the metal layer 17 preferably by 0.1 or more, and more preferably by 0.2 or more. The refractive index of the intermediate layer 20 is lower than the refractive index of the transparent conductive layer 15 preferably by 0.1 or more, and more preferably by 0.2 or more. More specifically, the refractive index of the intermediate layer 20 is preferably from 0.3 to 2.5, and more preferably from 1 to 2.

The thickness $T_{20}$ of the intermediate layer 20 is preferably 100 nm or more. The thickness of the intermediate layer 20 is preferably less than the thickness of the metal layer 17. In other words, the thickness of the metal layer 17 is preferably greater than the thickness of the intermediate layer 20.

However, a metal layer 17 functioning as a reflective layer has an electrical resistivity that is lower than the transparent conductive layer 15. Therefore, the extinction coefficient of the metal layer 17 is high. As a result, evanescent light occurring at the interface between the second semiconductor layer 13 and the transparent conductive layer 15 is readily absorbed by the metal layer 17. When evanescent light is absorbed by the metal layer 17, optical reflectance of the metal layer 17 is reduced by the amount of absorbed evanescent light. Here, evanescent light refers to the light leaking slightly towards the transparent conductive layer 15 or the metal layer 17 when all of the light is reflected at the interface between the second semiconductor layer 13 and the transparent conductive layer 15. This evanescent light is absorbed by the transparent conductive layer 15 and the metal layer 17. Therefore, the absorption of evanescent light by the transparent conductive layer 15 and the metal layer 17 has to be taken into account when reflectance is considered. This reduces the utilization efficiency of the light. As a result, the photoelectric conversion efficiency declines.

For this reason, an intermediate layer 20 is provided between the transparent conductive layer 15 and at least a portion of the metal layer 17 in the solar cell 1. The intermediate layer 20 has an electrical resistivity that is higher than the metal layer 17. Thus, the extinction coefficient of the intermediate layer 20 is smaller than the extinction coefficient of the metal layer 17. As a result, the evanescent light occurring at the interface of the second semiconductor layer 13 and the transparent conductive layer 15 is less readily absorbed by the intermediate layer 20. By arranging this intermediate layer 20 between the metal layer 17 and the transparent conductive layer 15, the percentage of the area in which the metal layer 17 readily absorbs evanescent light can be reduced relative to the area in which evanescent light is standing. Therefore, the absorption of light occurring in the interface between the second semiconductor layer 13 and the transparent conductive layer 15 can be suppressed. As a result, reduction of the optical reflectance by the metal layer 17 can be suppressed, the utilization efficiency of light can be increased, and improved photoelectric conversion efficiency can be realized.

In an embodiment able to increase the optical reflectance of the metal layer 17 and improve the utilization efficiency of light, the thickness of the semiconductor substrate 11 is preferably reduced, and the amount of light passing though the substrate 11 increased. More specifically, the thickness of the substrate 11 is more preferably 300 $\mu$m or less.

Another way to prevent the metal layer 17 from being located in the area in which evanescent light generated at the interface between the second semiconductor layer 13 and the transparent conductive layer 15 is standing would be to increase the thickness of the transparent conductive layer 15. However, this increases the amount of light absorbed by the transparent conductive layer 15. This is counterproductive as it reduces the utilization efficiency of the light.

In contrast, the thickness of the transparent conductive layer 15 does not have to be increased in the solar cell 1. As a result, any increase in the amount of light absorbed by the transparent conductive layer 15 can be suppressed.

From the standpoint of more effectively suppressing the absorption of light by the metal layer 17, it is preferable for the percentage of the area in which the intermediate layer 20 is provided to be increased relative to the area in which the metal layer 17 is provided, and for the intermediate layer 20 to be substantially provided in the entire region in which the metal layer 17 is provided. However, when the percentage of the area in which the intermediate layer 20 is provided is increased relative to the area in which the metal layer 17 is provided, the electrical resistivity of the intermediate layer 20 is higher than the electrical resistivity of the metal layer 17, and the resistance between the transparent conductive layer 15 and the metal layer 17 tends to increase. Therefore, the photoelectric conversion efficiency of the solar cell 1 may be reduced. From this standpoint, the percentage of the area in which the intermediate layer 20 is provided relative to the area in which the metal layer 17 is provided is preferably from 20% to 80%, and more preferably from 30% to 70%.

FIG. 4 is a graph representing the reflectivity of the metal layer at an optical wavelength of 1000 nm. In the graph shown in FIG. 4, the data is obtained from a simulation performed under the following conditions. The thickness shown in FIG. 4 is the thickness of the intermediate layer 20. The horizontal axis in FIG. 4 is the angle of incidence ($\theta$).

The intermediate layer 20 is provided in the entire region in which the metal layer 17 is provided.

2nd semiconductor layer 13: 9.1 nm-thick amorphous silicon layer.

Transparent conductive layer 15: 61.5 nm-thick indium oxide layer doped with W dopant.

Intermediate layer 20: Magnesium fluoride layer.

Metal layer 17: 400 nm-thick Ag layer.

It is clear from the graph shown in FIG. 4 that the optical reflectance of the metal layer 17 can be increased by providing an intermediate layer 20 with an electrical resistivity greater than that of the metal layer 17 but with an extinction coefficient that is smaller. It is also clear that the optical reflectance of the metal layer 17 can be increased even further when the thickness of the intermediate layer 20 is 100 nm or greater. From these results, it is clear that the thickness of the intermediate layer 20 is preferably 100 nm or greater. However, when the intermediate layer 20 is too thick and the intermediate layer 20 is thicker than the metal layer 17, the portion in which the metal layer 17 is positioned above the intermediate layer 20 and the portion in which the metal layer 17 is positioned in the region where the intermediate layer 20 is not provided may become decoupled in the metal layer 17 forming process due to a coverage problem. Therefore, the thickness of the intermediate layer 20 is preferably smaller than the thickness of the metal layer 17. In other words, the thickness of the metal layer 17 is preferably greater than the thickness of the intermediate layer 20.

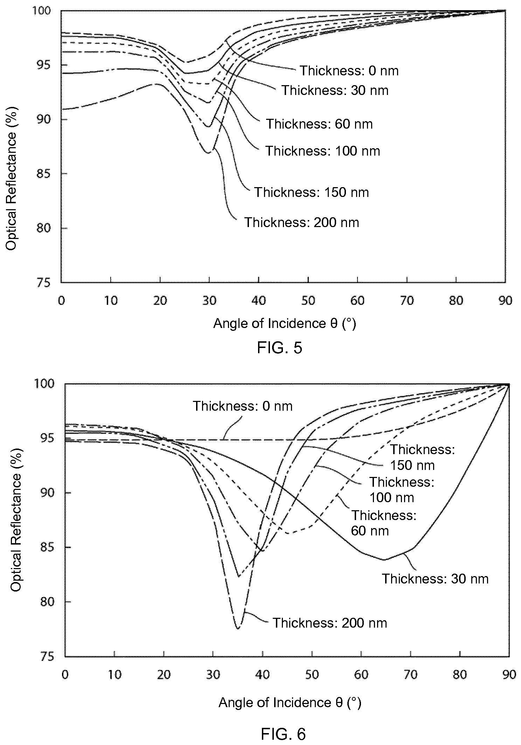

FIG. 5 is a graph representing the reflectivity of the metal layer of the solar cell in the present embodiment at an optical wavelength of 1000 nm. In the data shown in FIG. 5, the data is obtained from a simulation performed under the following conditions. The thickness shown in FIG. 5 is the thickness of the transparent conductive layer 15.

The intermediate layer 20 is provided in the entire region in which the metal layer 17.

2nd semiconductor layer 13: 9.1 nm-thick amorphous silicon layer.

Transparent conductive layer 15: indium oxide layer doped with W dopant.

Intermediate layer 20: 61.5 nm-thick magnesium fluoride layer.

Metal layer 17: 400 nm-thick Ag layer.

FIG. 6 is a graph representing the reflectivity at an optical wavelength of 1000 nm of the metal layer of a solar cell in a reference example having a configuration substantially identical to the solar cell in the embodiment, except that an intermediate layer 20 is not provided. The thickness shown in FIG. 6 is the thickness of the transparent conductive layer.

It is clear from the graphs in FIG. 5 and FIG. 6 that when an intermediate layer 20 is provided the minimum value of optical reflectance decreases monotonically as the thickness of the transparent conductive layer 15 increases. This does not occur when an intermediate layer 20 is not provided. It is clear from these results that the thickness of the transparent conductive layer 15 is preferably 100 nm or less when an intermediate layer 20 is provided.

Also, the refractive index of the intermediate layer 20 is preferably higher than the refractive index of the metal layer 17 but lower than the refractive index of the transparent conductive layer 15. Here, the light interference effect increases the reflectance.

The present invention includes many embodiments not described herein. As an example not forming part of the invention, the intermediate layer 20 may be provided over the entire area in which the metal layer 17 is provided. In this case, the absorption of evanescent light can be more effectively suppressed.

The photoelectric conversion unit does not have to have a HIT structure. Polycrystalline silicon, thin-film silicon, or CIGS may be used.

The solar cell may also be a back contact solar cell in which the first and second electrodes are arranged on a single main surface.

The present invention includes many other embodiments not described herein. Therefore, the technical scope of the present invention is defined solely by the items of the invention specified in the claims pertinent to the above explanation.

Key to the Drawings

1: Solar cell
10: Photoelectric conversion unit
11: Substrate
12: 1st semiconductor layer
13: 2nd semiconductor layer
14: 1st transparent conductive layer
15: 2nd transparent conductive layer
17: Metal layer
20: Intermediate layer

**Claims**

1. A solar cell comprising:

    a photoelectric conversion unit (10) including a transparent conductive layer (15) on a surface;
    a metal layer (17) arranged on the transparent conductive layer (15); and
    an intermediate layer (20) arranged between the metal layer (17) and the transparent conductive layer (15) and shaped in stripes each of which extends in a first direction, the intermediate layer (20) having a smaller extinction coefficient than the metal layer (17); **characterized in that** the surface of the metal layer (17) is formed in an uneven shape due to the stripe-shaped intermediate layer (20) and
    linear electrodes are (18) formed on the surface of the metal layer (17) and extending in the first direction.

2. The solar cell according to claim 1, wherein the intermediate layer (20) has a higher electrical resistivity than the metal layer (17), and is arranged between the transparent conductive layer (15) and a portion of the metal layer (17).

3. The solar cell according to claim 2, wherein the area ratio of the area in which the intermediate layer (20) is provided relative to the area in which the metal layer (17) is provided is from 20% to 80%.

4. The solar cell according to claim 2 or claim 3, wherein the thickness of the metal layer (17) is greater than the thickness of the intermediate layer (20).

5. The solar cell according to any one of claims 1 through 4, wherein the refractive index of the intermediate layer (20) is greater than the refractive index of the metal layer (17), but less than the refractive index of the transparent conductive layer (15).

6. The solar cell according to any one of claims 1 through 5, wherein the intermediate layer (20) is made of at least one type of material selected from a group including magnesium fluoride, silicon nitride, aluminum oxide, calcium fluoride, and magnesium oxide.

7. The solar cell according to any one of claims 1 through 6, wherein the metal layer (17) is made of at least one type of element selected from a group including Ag, Cu, Ni, Mn, Cr, Sn, Mg, W, Co, and Zn.

8. The solar cell according to any one of claims 1 through 7, wherein the photoelectric conversion unit (10) includes a substrate (11) made of crystalline silicon, and the thickness of the substrate (11) is 300 $\mu$m or less.

**Patentansprüche**

1. Solarzelle, die Folgendes umfasst:

   eine fotoelektrische Wandlereinheit (10), die eine transparente leitfähige Schicht (15) auf einer Oberfläche einschließt;
   eine Metallschicht (17), die auf der transparenten leitfähigen Schicht (15) angeordnet ist; und
   eine Zwischenschicht (20), die zwischen der Metallschicht (17) und der transparenten leitfähigen Schicht (15) angeordnet ist und in Streifen geformt ist, von denen sich jeder in einer ersten Richtung erstreckt, wobei die Zwischenschicht (20) einen kleineren Extinktionskoeffizienten als die Metallschicht (17) aufweist;
   **dadurch gekennzeichnet, dass** die Oberfläche der Metallschicht (17) wegen der streifenförmigen Zwischenschicht (20) in einer unebenen Form gebildet ist und lineare Elektroden (18) auf der Oberfläche der Metallschicht (17) gebildet sind und sich in der ersten Richtung erstrecken.

2. Solarzelle gemäß Anspruch 1, wobei die Zwischenschicht (20) einen höheren elektrischen Widerstandswert als die Metallschicht (17) aufweist und zwischen der transparenten leitfähigen Schicht (15) und einem Teil der Metallschicht (17) angeordnet ist.

3. Solarzelle gemäß Anspruch 2, wobei das Flächenverhältnis der Fläche, in der die Zwischenschicht (20) bereitgestellt ist, bezogen auf die Fläche, in der die Metallschicht (17) bereitgestellt ist, von 20 % bis 80 % beträgt.

4. Solarzelle gemäß Anspruch 2 oder 3, wobei die Dicke der Metallschicht (17) größer ist als die Dicke der Zwischenschicht (20).

5. Solarzelle gemäß einem der Ansprüche 1 bis 4, wobei der Brechungsindex der Zwischenschicht (20) größer ist als der Brechungsindex der Metallschicht (17), aber weniger als der Brechungsindex der transparenten leitfähigen Schicht (15) ist.

6. Solarzelle gemäß einem der Ansprüche 1 bis 5, wobei die Zwischenschicht (20) aus mindestens einer Art von Material hergestellt ist, das ausgewählt ist aus einer Gruppe, die Magnesiumfluorid, Siliciumnitrid, Aluminiumoxid, Calciumfluorid und Magnesiumoxid einschließt.

7. Solarzelle gemäß einem der Ansprüche 1 bis 6, wobei die Metallschicht (17) aus mindestens einer Art von Element hergestellt ist, das ausgewählt ist aus einer Gruppe, die Ag, Cu, Ni, Mn, Cr, Sn, Mg, W, Co und Zn einschließt.

8. Solarzelle gemäß einem der Ansprüche 1 bis 7, wobei die fotoelektrische Wandlereinheit (10) ein Substrat (11) einschließt, das aus kristallinem Silicium hergestellt ist, und die Dicke des Substrats (11) 300 $\mu$m oder weniger beträgt.

**Revendications**

1. Cellule solaire comprenant :

une unité de conversion photoélectrique (10) comprenant une couche conductrice transparente (15) sur une surface ;
une couche métallique (17) disposée sur la couche conductrice transparente (15) ; et
une couche intermédiaire (20) disposée entre la couche métallique (17) et la couche conductrice transparente (15) et ayant une forme en bandes dont chacune s'étend dans une première direction, la couche intermédiaire (20) ayant un coefficient d'extinction inférieur à celui de la couche métallique (17) ;
**caractérisée en ce que** la surface de la couche métallique (17) est formée sous une forme irrégulière en raison de la couche intermédiaire en forme de bandes (20), et des électrodes linéaires sont (18) formées sur la surface de la couche métallique (17) et s'étendent dans la première direction.

2. Cellule solaire selon la revendication 1, la couche intermédiaire (20) ayant une résistivité électrique supérieure à celle de la couche métallique (17), et étant disposée entre la couche conductrice transparente (15) et une partie de la couche métallique (17)

3. Cellule solaire selon la revendication 2, le rapport de surface de la zone dans laquelle la couche intermédiaire (20) est fournie, par rapport à la zone dans laquelle la couche métallique (17) est fournie, étant de 20 % à 80 %.

4. Cellule solaire selon la revendication 2 ou la revendication 3, l'épaisseur de la couche métallique (17) étant supérieure à l'épaisseur de la couche intermédiaire (20).

5. Cellule solaire selon l'une quelconque des revendications 1 à 4, l'indice de réfraction de la couche intermédiaire (20) étant supérieur à l'indice de réfraction de la couche métallique (17), mais inférieur à l'indice de réfraction de la couche conductrice transparente (15).

6. Cellule solaire selon l'une quelconque des revendications 1 à 5, la couche intermédiaire (20) étant constituée d'au moins un type de matériau choisi dans un groupe comprenant le fluorure de magnésium, le nitrure de silicium, l'oxyde d'aluminium, le fluorure de calcium et l'oxyde de magnésium.

7. Cellule solaire selon l'une quelconque des revendications 1 à 6, la couche métallique (17) étant constituée d'au moins un type d'élément choisi dans un groupe comprenant Ag, Cu, Ni, Mn, Cr, Sn, Mg, W, Co et Zn.

8. Cellule solaire selon l'une quelconque des revendications 1 à 7, l'unité de conversion photoélectrique (10) comprenant un substrat (11) constitué de silicium cristallin, et l'épaisseur du substrat (11) étant de 300 $\mu$m ou moins.

FIG. 1

FIG. 2

FIG. 3

FIG. 4

FIG. 5

FIG. 6

**EP 2 738 819 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8508368 W

- JP H7321362 B